# EUROPEAN PATENT SPECIFICATION

(11) **EP 2 003 705 B1**
(45) Date of publication and mention of the grant of the patent: **07.03.2018**
(21) Application number: 07739448.4
(22) Date of filing: 23.03.2007
(51) Int. Cl.: H01L 33/14, H01L 33/32, H01L 33/20

(54) **METHOD FOR MANUFACTURING GALLIUM NITRIDE COMPOUND SEMICONDUCTOR LIGHT-EMITTING DEVICE, GALLIUM NITRIDE COMPOUND SEMICONDUCTOR LIGHT-EMITTING DEVICE AND LAMP USING SAME**
VERFAHREN ZUR HERSTELLUNG EINER GALLIUMNITRIDVERBINDUNGSHALBLEITERLEUCHTANORDNUNG, GALLIUMNITRIDVERBINDUNGSHALBLEITERLEUCHTANLEITUNG UND LAMPE DAMIT
PROCEDE DE FABRICATION DE DISPOSITIF ELECTROLUMINESCENT A BASE DE COMPOSE SEMI-CONDUCTEUR DE NITRURE DE GALLIUM, DISPOSITIF ELECTROLUMINESCENT A BASE DE COMPOSE SEMI-CONDUCTEUR DE NITRURE DE GALLIUM ET LAMPE UTILISANT CE DISPOSITIF

(30) Priority: 23.03.2006 JP 2006080883
(43) Date of publication of application: 17.12.2008
(73) Proprietor: Toyoda Gosei Co., Ltd., Kiyosu-shi Aichi 452-8564 (JP)
(72) Inventor: SHINOHARA, Hironao, Ichihara-shi, Chiba 290-0067 (JP); MURAKI, Noritaka, c/o Showa Denko K.K., Chichibu-shi, Saitama 3691893 (JP); OSAWA, Hiroshi, c/o Showa Denko K.K., Minato-ku, Tokyo 1058518 (JP)
(74) Representative: Strehl Schübel-Hopf & Partner
(86) International application number: PCT/JP2007/056007
(87) International publication number: WO 2007/108532

(56) References cited:
- EP-A2- 0 845 818
- GB-A- 2 280 308
- JP-A- 2003 258 296
- JP-A- 2005 005 679
- JP-A- 2005 109 283
- JP-A- 2005 354 020
- JP-A- 2006 140 357
- US-A1- 2006 006 407

## Description

### TECHNICAL FIELD

The present invention relates to a method for producing a gallium nitride based compound semiconductor light emitting device, in particular, a method for producing a gallium nitride based compound semiconductor light emitting device having excellent light emitting properties, and also relates to a gallium nitride based compound semiconductor light emitting device and a lamp using the same.

Priority is claimed on Japanese Patent Application No. 2006-080883, filed March 23, 2006.

### BACKGROUND ART

In recent years, a GaN-based compound semiconductor material that is a nitride based semiconductor has been attracting attention as a semiconductor material for a light emitting device emitting short wavelength light. Using various oxides or group III-V compounds such as a sapphire single crystal as a substrate, a GaN-based compound semiconductor is formed on this substrate using a metal organic chemical vapor deposition (MOCVD) method, a molecular beam epitaxy (MBE) method, or the like.

Characteristics of GaN-based compound semiconductor materials include small current diffusion in the lateral direction. Due to this, an electric current is applied only to the semiconductor located immediately below an electrode and the light emitted in a light emitting layer is screened by the electrode, which makes it difficult to emit light from the light emitting device to the outside. Accordingly, with such a light emitting device, a translucent positive electrode is usually used and light is emitted through the translucent positive electrode.

Conventional translucent positive electrodes have been configured as a layered structure in which an oxide such as Ni or Co is combined with a contact metal such as Au. In addition, in recent years, a layered structure, in which translucency is enhanced by reducing the film thickness of the contact metal as much as possible due to the use of oxides having higher electrical conductivity such as indium tin oxide (ITO), is adopted as a positive electrode, and it is configured so that the light from the light emitting layer can be efficiently emitted to the outside.

The external quantum efficiency is used as an indicator for the improvements in the output of such light emitting devices. When this external quantum efficiency is high, it is possible to say that the light emitting device has a high output.

The external quantum efficiency is represented by the product of internal quantum efficiency and light emission efficiency.

The internal quantum efficiency refers to the ratio at which the energy of an electric current applied to the device is converted to light. On the other hand, the light emission efficiency refers to the ratio of light emitted to the outside to light generated from the inside of a semiconductor crystal.

The internal quantum efficiency of the light emitting devices described above is said to have increased up to about 70 to 80% due to the improvements in the state or structure of the crystal, and thus satisfactory effects with respect to the amount of applied electric current have been attained.

However, in light emitting diodes in general and not only in the GaN-based compound semiconductor, the light emission efficiency with respect to the amount of electric current applied is low in most cases and it cannot be said that light emitted inside the devices is sufficiently emitted to the outside considering the amount of electric current applied.

The cause for this low light emission efficiency is that since the light emitting layer of a GaN-based compound semiconductor has a refractive index of about 2.5 which is considerably higher than that of air, which is 1, and has a small critical angle of about 25°, light is repeatedly reflected/absorbed inside the crystal and cannot be emitted to the outside.

In order to improve the light emission efficiency of light emitting devices, a gallium nitride based compound semiconductor light emitting device has been proposed in which light emission efficiency is improved by roughening a light emitting surface to provide various angles within the light emitting surface (for example, refer to Patent Document 1).

However, in the light emitting device described in Patent Document 1, a large resistance is generated between a translucent positive electrode and a p-type semiconductor layer due to the damage caused by the dry etching process which results in a problem of an extremely large driving voltage.

[Patent Document 1] Japanese Unexamined Patent Application, First Publication No. Hei 6-291368
US 2006/006407 A1 discloses a method for producing a gallium nitride based compound semiconductor light emitting device comprising a first crystal growth step, a second crystal growth step, an uneven pattern forming step and a heat treatment step.

### DISCLOSURE OF INVENTION

### PROBLEMS TO BE SOLVED BY THE INVENTION

The present invention is made in view of the above problems and its object is to provide a method for producing a gallium nitride based compound semiconductor light emitting device that is excellent in terms of light emission efficiency and is also capable of operating at a low driving voltage, a gallium nitride based compound semiconductor light emitting device, and a lamp using the device.

### MEANS FOR SOLVING THE PROBLEMS

The present inventors completed the present invention as a result of intensive studies in order to solve the above problems.

That is, the present invention relates to the following.

[1] A method for producing a gallium nitride based compound semiconductor light emitting device (1), the method comprising:
   a first crystal growth step in which an n-type semiconductor layer (13), a light emitting layer (14), and a first p-type semiconductor layer (15) which are formed of a gallium nitride based compound semiconductor are laminated in this order on a substrate (11);
   a second crystal growth step in which a second p-type semiconductor layer (16) formed of a gallium nitride based compound semiconductor is further laminated thereon;
   an uneven pattern forming step in which an uneven pattern is formed on a surface of the first p-type semiconductor layer (15) after the first crystal growth step and before the second crystal growth step; and
   a heat treatment step in which a heat treatment is carried out after the uneven pattern forming step,
   characterized in that
   the heat treatment step is carried out in an oxygen atmosphere and the uneven pattern forming step includes the following intermediate steps (a) and (b):
      (a) a step for forming a mask on the first p-type semiconductor layer (15); and
      (b) a step for dry etching a surface of the first p-type semiconductor layer (15).
[2] The method for producing a gallium nitride based compound semiconductor light emitting device according to [1] above,
   wherein a heat treatment temperature in the heat treatment step is greater than or equal to 250°C.
[3] The method for producing a gallium nitride based compound semiconductor light emitting device according to [1] above,
   wherein a heat treatment temperature in the heat treatment step is greater than or equal to 500°C.
[4] The method for producing a gallium nitride based compound semiconductor light emitting device according to [1] above,
   wherein the mask is formed on the first p-type semiconductor layer (15) in the step (a) by carrying out a patterning process using a resist material.
[5] The method for producing a gallium nitride based compound semiconductor light emitting device according to [1] above,
   wherein the step (a) includes a sub-step for forming a metal thin film on the first p-type semiconductor layer (15) and a sub-step for carrying out a heat treatment after forming the metal thin film.
[6] The method for producing a gallium nitride based compound semiconductor light emitting device according to [5] above,
   wherein the metal thin film formed in step (a) remains in the first p-type semiconductor layer (15) or on a surface thereof after a dry etching process in the step (b).
[7] The method for producing a gallium nitride based compound semiconductor light emitting device according to [5] or [6] above,
   wherein the metal thin film is made of a low melting point metal or a low melting point alloy which has a melting point of 100°C to 450°C.
[8] The method for producing a gallium nitride based compound semiconductor light emitting device according to [5] or [6] above,
   wherein the metal thin film is made of Ni or a Ni alloy.
[9] The method for producing a gallium nitride based compound semiconductor light emitting device according to any one of [5] to [8] above,
   wherein the metal thin film is made of a low melting point metal selected from the group consisting of Ni, Au, Sn, Ge, Pb, Sb, Bi, Cd, and In or a low melting point alloy containing at least one of these metals.

### EFFECTS OF THE INVENTION

According to the method for producing a gallium nitride based compound semiconductor light emitting device of the present invention, a gallium nitride based compound semiconductor light emitting device that is excellent in terms of light emission efficiency and is capable of operating at a low driving voltage is obtained. In addition, the production method of the present invention has effects, especially the following effects (1) and (2).
(1) an uneven pattern with no damage caused by the dry etching process can be formed on the surface of the first p-type semiconductor layer.
(2) A crystal plane inclined with respect to the substrate normal direction is exposed in the surface since the second p-type semiconductor layer is laminated and regrown. Due to this, the step coverage characteristics of the translucent positive electrode improve.

Due to these effects, a gallium nitride based compound semiconductor light emitting device that is excellent in terms of light emission efficiency and is capable of operating at a low driving voltage is obtained.

In addition, a lamp that is highly reliable and has excellent light emitting properties is obtained by using a gallium nitride based compound semiconductor light emitting device produced by the method of the present invention.

### BRIEF DESCRIPTION OF THE DRAWINGS

FIG. 1 is a diagram schematically describing one example of a light emitting device produced by the method of the present invention and is a schematic diagram showing a cross sectional structure thereof.
FIG. 2 is a diagram schematically describing the light emitting device produced by the method of the present invention and is a schematic diagram showing a planar structure of the light emitting device shown in FIG. 1.
FIG. 3 is a diagram schematically describing one example of a lamp comprising the light emitting device produced by the method of the present invention and is a schematic diagram showing a cross sectional structure thereof.

### DESCRIPTION OF THE REFERENCE SYMBOLS

1: Light emitting device; 2: Lamp; 11: Substrate; 12: Buffer layer; 13: n-type semiconductor layer; 14: Light emitting layer; 15: First p-type semiconductor layer; 16: p-contact layer (second p-type semiconductor layer); 17: Translucent positive electrode; 18: Positive electrode bonding pad; 19: Negative electrode bonding pad

### BEST MODE FOR CARRYING OUT THE INVENTION

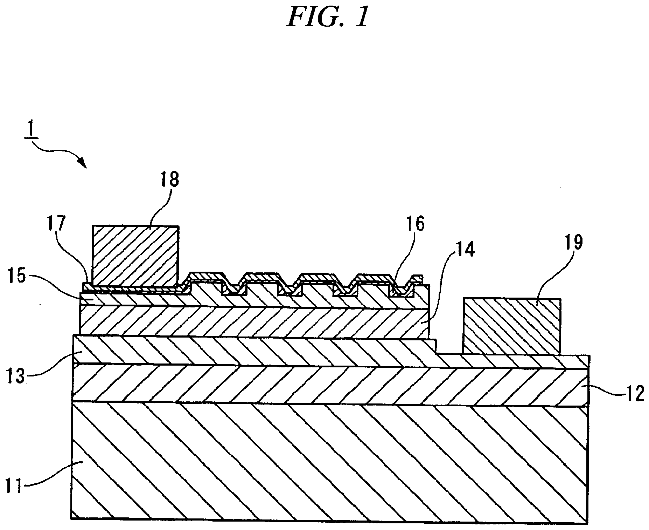

One embodiment of the method for producing a gallium nitride based compound semiconductor light emitting device (hereinafter also referred to as a light emitting device) of the present invention, the gallium nitride based compound semiconductor light emitting device, and the lamp using the device will be described below while referring to FIGS. 1 to 3 where appropriate.

Note that the present invention is not limited to each element of the following embodiment and, for example, constituting elements in this embodiment may be combined where appropriate.

The method of the present invention for producing a gallium nitride based compound semiconductor light emitting device includes a first crystal growth step in which an n-type semiconductor layer 13, a light emitting layer 14, and a first p-type semiconductor layer 15 which are formed of a gallium nitride-based compound semiconductor are laminated in this order on a substrate 11 as shown in FIG. 1; and a second crystal growth step in which a p-contact layer (a second p-type semiconductor layer) formed of a gallium nitride based compound semiconductor is further laminated thereon; and also has an uneven pattern forming step in which an uneven pattern is formed on a surface of the first p-type semiconductor layer 15 before the first crystal growth step and after the second crystal growth step; and a heat treatment step in which a heat treatment is carried out after the uneven pattern forming step.

In the method of the present invention for producing a light emitting device, driving voltage of the light emitting device is lowered and its light emission efficiency is improved by forming an uneven pattern having no damage caused by the etching process on the surface of the first p-type semiconductor layer 15 of the light emitting surface.

Examples of the major phenomena caused by the etching damages include an extreme reduction of impurity concentration in the surface of the p-type semiconductor layer. Various proposals have been made including the method described in Japanese Unexamined Patent Application, First Publication No. 2000-196152 in order to restore this damage.

However, the method proposed in Japanese Unexamined Patent Application, First Publication No. 2000-196152 does not fully restore the damage which results in a subsequent increase in the driving voltage. The present inventors discovered that the etching damage are sufficiently restored and the driving voltage reduces due to the method described below.

### [Configuration of gallium nitride based compound semiconductor light emitting device]

FIG. 1 is a diagram schematically showing a cross section of the light emitting device obtained in the present invention.

In FIG. 1, reference numerals 11, 12, 13, 14, 15, 16, 17, 18, and 19 represent a substrate, a buffer layer, an n-type semiconductor layer, a light emitting layer, a first p-type semiconductor layer, a p-contact layer (a second p-type semiconductor layer), a translucent positive electrode, a positive electrode bonding pad, and a negative electrode bonding pad, respectively.

In the light emitting device an uneven pattern is formed on the surface of the first p-type semiconductor layer 15 and a p-contact layer 16 is further laminated thereon as in the example shown in FIG. 1. In addition, in the example shown in the drawing, the second p-type semiconductor layer 16 and the translucent positive electrode 17 are formed unevenly so as to follow the uneven pattern formed on the surface of the first p-type semiconductor layer 15.

The light emitting device will be described in detail below.

### [Substrate]

For the substrate 11, known substrate materials including oxide single crystals such as a sapphire single crystal (Al₂O₃; A-plane, C-plane, M-plane, and R-plane), a spinel single crystal (MgAl₂O₄), a ZnO single crystal, a LiAlO₂ single crystal, a LiGaO₂ single crystal and a MgO single crystal, a Si single crystal, a SiC single crystal, a GaAs single crystal, an AlN single crystal, a GaN single crystal, and boride single crystals such as a ZrB₂ single crystal are used. Also in the present invention, any substrate materials including these known substrate materials can be used without any limitations. Among these, a sapphire single crystal and a SiC single crystal are particularly preferable.

Note that the plane direction of a substrate is not particularly limited. In addition, the substrate may be a just substrate or a substrate having an off angle.

### [Gallium nitride based compound semiconductor]

The n-type semiconductor layer 13, the light emitting layer 14, and the first p-type semiconductor layer 15 which are formed of a gallium nitride-based compound semiconductor are usually laminated on the substrate 11 with the buffer layer 12 interposed therebetween. Note that there are cases where the buffer layer 12 is not required depending on the type of substrate used or the growth conditions of an epitaxial layer.

In addition, in the light emitting device, an uneven pattern is formed on the surface of the first p-type semiconductor layer 15 and the p-contact layer (second p-type semiconductor layer) 16 is further laminated on the first p-type semiconductor layer 15 as in the example shown in FIG. 1.

Various kinds of gallium nitride based compound semiconductors have been known which are represented by general formula Al_{X}Ga_{Y}In_{Z}N_{1-A}M_{A} (0 ≤ X <1, 0 ≤ Y ≤1, 0 ≤ Z ≤1, as well as X + Y + Z = 1, and the symbol M represents a group V element different from nitrogen (N) and 0 ≤ A <1). The present invention can also use any kind of gallium nitride based compound semiconductor represented by the general formula Al_{X}Ga_{Y}In_{Z}N_{1-A}M_{A} (0 ≤ X <1, 0 ≤ Y ≤1, 0 ≤ Z ≤1, as well as X + Y + Z = 1, and the symbol M represents a group V element different from nitrogen (N) and 0 ≤ A <1) including those already known gallium nitride based compound semiconductors.

The gallium nitride based compound semiconductor can contain other group III elements in addition to Al, Ga, and In and elements such as Ge, Si, Mg, Ca, Zn, Be, P, As, and B can also be contained if necessary. Moreover, the elements contained are not limited to those added intentionally and there are also cases where the semiconductor contains impurities that are inevitably contained depending on the film forming conditions and the like as well as the trace impurities contained in the source materials and the reaction tube materials.

The method for growing gallium nitride based compound semiconductor is not particularly limited and all the methods that are known to grow a nitride semiconductor such as the metalorganic chemical vapor deposition (MOCVD) method, the hydride vapor phase epitaxy (HVPE) method, and the molecular beam epitaxy (MBE) method can be applied. The preferable growing method is the MOCVD method in view of its film thickness controllability and mass productivity.

In the MOCVD method, hydrogen (H₂) or nitrogen (N₂), trimethylgallium (TMG) or triethylgallium (TEG), trimethylaluminum (TMA) or triethylaluminum (TEA), trimethylindium (TMI) or triethylindium (TEI), and ammonia (NH₃), hydrazine (N₂H₄), or the like are used as a carrier gas; a Ga source, an Al source, and an In source which are group III materials; and an N source which is a group V material, respectively. In addition, as a dopant, monosilane (SiH₄) or disilane (Si₂H₆), and germane gas (GeH₄) or organic germanium compounds such as tetramethylgermanium ((CH₃)₄Ge) and tetraethylgermanium ((C₂H₅)₄Ge) can be used in the n-type semiconductor as a Si source material and a Ge source material, respectively.

In the MBE method, elemental germanium can also be used as a doping source. For example, biscyclopentadienyl magnesium (Cp₂Mg) or bisethylcyclopentadienyl magnesium (EtCp₂Mg) is used as an Mg source material for the p-type semiconductor.

### (n-type semiconductor layer)

The n-type semiconductor layer 13 is usually configured from a underlying layer, an n-contact layer, and an n-cladding layer. The n-contact layer can also serve as an underlying layer and/or an n-cladding layer.

The underlying layer is preferably constituted from an Al_{X}Ga_{1-X}N layer (0 ≤ X ≤ 1, preferably 0 ≤ X ≤ 0.5 and more preferably 0 ≤ X ≤ 0.1). Film thickness of the underlying layer is preferably greater than or equal to 0.1 µm, more preferably greater than or equal to 0.5 µm, and most preferably greater than or equal to 1 µm. The Al_{X}Ga_{1-X}N layer with satisfactory crystallinity is likely to be obtained by making the film thickness greater than or equal to 1 µm.

Although n-type impurities may be doped in the underlying layer as long as the concentration thereof is within the range of 1 × 10¹⁷ to 1 × 10¹⁹/cm³, it is preferable that the underlying layer is undoped (that is, the concentration is < 1 × 10¹⁷/cm³) in view of the maintenance of satisfactory crystallinity. Although n-type impurities are not particularly limited, examples thereof include Si, Ge, and Sn and Si and Ge are preferable.

Growth temperature for growing the underlying layer is preferably 800 to 1,200°C and it is more preferable to adjust it within the range of 1,000 to 1,200°C. The underlying layer with satisfactory crystallinity is obtained when it is grown within this temperature range. In addition, it is preferable to adjust the pressure inside the MOCVD growth furnace within the range of 15 to 40 kPa.

Similar to the underlying layer, the n-contact layer is preferably constituted from an Al_{X}Ga_{1-X}N layer (0 ≤ X ≤ 1, preferably 0 ≤ X ≤ 0.5 and more preferably 0 ≤ X ≤ 0.1). In addition, it is preferable that n-type impurities are doped and it is preferable to contain n-type impurities within a concentration range of 1 × 10¹⁷ to 1 × 10¹⁹/cm³, more preferably 1 × 10¹⁸ to 1 × 10¹⁹/cm³ for maintaining a satisfactory ohmic contact with the negative electrode, suppressing the generation of cracks, and maintaining satisfactory crystallinity. Although n-type impurities are not particularly limited, examples thereof include Si, Ge, and Sn and Si and Ge are preferable. Preferable range of the growth temperature for the n-contact layer is the same as that of the underlying layer.

It is preferable that the gallium nitride based compound semiconductor constituting the n-contact layer has the same composition as that of the underlying layer and it is preferable to set the total thickness of these film layers within the range of 1 to 20 µm, more preferably 2 to 15 µm, and even more preferably 3 to 12 µm. The crystallinity of semiconductor is satisfactorily maintained when the sum of the film thickness of the n-contact layer and the underlying layer is within this range.

It is preferable to provide an n-cladding layer between the n-contact layer and the light emitting layer 14.By providing an n-cladding layer, the areas with impaired smoothness generated on the outermost surface of the n-contact layer can be filled. The n-cladding layer can be formed with AlGaN, GaN, GaInN, or the like. In addition, it is also possible to configure a heterojunction of these structures or a superlattice structure where these structures are laminated several times. Needless to say, when GaInN is used, it is desirable that its bandgap is larger than that of GaInN in the light emitting layer.

Although the film thickness of the n-cladding layer is not particularly limited, it is preferably within the range of 0.005 to 0.5 µm and more preferably within the range of 0.005 to 0.1 µm.

In addition, the n-type dopant concentration in the n-cladding layer is preferably within the range of 1 × 10¹⁷ to 1 × 10²⁰/cm³ and more preferably within the range of 1 × 10¹⁸ to 1 × 10¹⁹/cm³. It is preferable that the dopant concentration be within this range for maintaining satisfactory crystallinity and for reducing the operating voltage of the light emitting device.

### (Light emitting layer)

A light emitting layer constituted of a gallium nitride based compound semiconductor, preferably a gallium nitride based compound semiconductor made of Ga_{1-S}In_{S}N (0 < S < 0.4) is usually used as the light emitting layer 14 that is laminated on the n-type semiconductor layer 13.

Although the film thickness of the light emitting layer 14 is not particularly limited, the film thickness where the quantum effect is achieved, that is, the critical film thickness is preferable and it is within the range of 1 to 10 nm, for example, and more preferably within the range of 2 to 6 nm. It is preferable that the film thickness be within the above range from a viewpoint of emission power.

In addition, apart from the abovementioned single quantum well (SQW) structure, the light emitting layer may also be configured as a multiple quantum well (MQW) structure constituted from the abovementioned Ga_{1-S}In_{S}N layer as a well layer and an Al_{c}Ga_{1-c}N (0 ≤ c <0.3 as well as b > c) barrier layer having a higher bandgap energy than that of the well layer. Moreover, the well layer and the barrier layer may be doped with impurities.

Growth temperature of the Al_{c}Ga_{1-c}N barrier layer is preferably greater than or equal to 700°C, and it is more preferable to grow the layer at a temperature of 800°C to 1,100°C since satisfactory crystallinity is achieved. In addition, the GaInN well layer is grown at a temperature of 600 to 900°C, more preferably 700 to 900°C. In other words, the growth temperature is preferably changed for different layers in order to achieve satisfactory crystallinity of the MQW structure.

### (First p-type semiconductor layer)

The first p-type semiconductor layer 15 is usually constituted from a p-cladding layer and a p-contact layer. However, the p-contact layer may also serve as the p-cladding layer.

The p-cladding layer is not particularly limited as long as it has a composition that has a higher bandgap energy than that of the light emitting layer and it can confine carries in the light emitting layer 14, and the preferable examples thereof include an Al_{d}Ga_{1-d}N (0 < d ≤ 0.4, preferably 0.1 ≤ d ≤ 0.3) layer. It is preferable that the p-cladding layer be formed from such an AlGaN layer from the viewpoint of the confinement of carriers in the light emitting layer 14.

Although the film thickness of the p-cladding layer is not particularly limited, it is preferably within the range of 1 to 400 nm and more preferably within the range of 5 to 100 nm.

The p-type dopant concentration in the p-cladding layer is preferably within the range of 1 × 10¹⁸ to 1 × 10²¹/cm³ and more preferably within the range of 1 × 10¹⁹ to 1 × 10/cm³. Satisfactory p-type crystals are obtained without reducing the crystallinity thereof when the p-type dopant concentration is within the abovementioned range.

The p-contact layer is a gallium nitride based compound semiconductor layer containing at least AlₑGa₁₋ₑN (0 ≤ e < 0.5, preferably, 0 ≤ e ≤ 0.2, more preferably, 0 ≤ e ≤ 0.1). It is preferable that the Al composition be within the above range for maintaining satisfactory crystallinity and for satisfactory ohmic contact with a p-ohmic electrode.

In addition, it is preferable that the p-type dopant concentration be within the range of 1 × 10¹¹ to 1 × 10²¹/cm³ for maintaining a satisfactory ohmic contact, preventing the occurrence of cracks, and maintaining satisfactory crystallinity, and more preferably, the concentration is within the range of 5 × 10¹⁹ to 5 × 10²⁰/cm³.

Although p-type impurities are not particularly limited, preferable examples thereof include Mg.

The thickness of the p-contact layer is not particularly limited, but is preferably within the range of 0.2 to 4 µm and more preferably 0.4 to 2 µm. It is preferable that the film thickness be within this range from a viewpoint of emission power.

### (Uneven pattern on surface of first p-type semiconductor layer)

An uneven pattern is formed on the surface of the first p-type semiconductor layer in the light emitting device as in the example shown in FIG. 1.

In the present invention, by adopting a configuration where an uneven pattern is formed on the surface of the first p-type semiconductor layer 15, which is the light emitting surface, a light emitting device with excellent light emitting properties can be achieved due to the reduction in the driving voltage of the light emitting device and the improvements in the light emission efficiency.

### (Second p-type semiconductor layer)

As described earlier, in the light emitting device, the p-contact layer (second p-type semiconductor layer) 16 is laminated on the first p-type semiconductor layer 15, in which an uneven pattern is formed on the surface thereof. In addition, in the example shown in FIG. 1, the p-contact layer 16 is formed unevenly so as to follow the uneven pattern formed on the surface of the first p-type semiconductor layer 15.

Preferable film thickness of the p-contact layer 16 differs depending on the method used in the step for forming an uneven pattern on the surface of the first p-type semiconductor layer, on which the p-contact layer 16 is laminated. For example, when the formation of an uneven pattern is conducted by preparing a common resist mask with any given pattern due to a photolithography method, the film thickness is preferably within the range of 50 nm to 500 nm.

When the film thickness of the p-contact layer 16 is too large, the uneven pattern will be planarized. Accordingly, it is not preferable from the viewpoint of light emission. On the other hand, when the film thickness of the p-contact layer 16 is too small, an inclined crystal plane does not develop, and thus it is not preferable from the viewpoint of the step coverage characteristics of a translucent positive electrode.

### <Translucent positive electrode>

As shown in the example of FIG. 1, the translucent positive electrode 17 is formed directly on the p-contact layer 16 or above the p-contact layer 16 while interposing a metal layer or the like therebetween. In addition, in the example shown in FIG. 1, the translucent positive electrode 17 is formed unevenly, together with the second p-contact layer 16, so as to follow the uneven pattern formed on the surface of the first p-type semiconductor layer 15.

For example, metals such as Au, Ni, Co, Cu, Pd, Pt, Rh, Os, Ir, and Ru can be used for the translucent positive electrode 17. In addition, the translucent positive electrode may contain a transparent oxide such as ITO, NiO, and CoO. The transparent oxide may be contained in the abovementioned metal film in the form of a mass or may be contained by being superposed on the abovementioned metal film in the form of a layer. These known materials and structures can be adopted without any limitations.

In addition, the translucent positive electrode 17 can be formed, for example, by using materials that include at least one of the transparent oxides such as ITO(In₂O₃-SnO₂), AZnO(ZnO-Al₂O₃), IZnO(In₂O₃-ZnO), and GZO(ZnO-GeO₂) by a means that has been well known in this technical field. Moreover, the translucent positive electrode can adopt any structures without any limitations including the structures already known.

The translucent positive electrode 17 may be formed so as to cover substantially the entire surface of the p-contact layer 16, or it may be formed in a lattice shape or a tree shape with gaps present. After the translucent positive electrode 17 is formed, a thermal annealing process may be conducted for alloying or increasing transparency, or it may not be conducted.

In addition, as shown in FIG. 1, the form of the light emitting device may be a face up (FU) type in which light is emitted from the semiconductor side using the translucent positive electrode or a flip chip (FC) type in which light is emitted from the substrate side using a reflective positive electrode.

### <Positive electrode bonding pad and negative electrode bonding pad>

A positive electrode bonding pad 18 is provided on the translucent positive electrode 17 as shown in the example of FIG. 1.

As the materials for the positive electrode bonding pad 18, various structures using, for example, Au, Al, Ni, Cu, or the like are known and these known materials and structures can be used without any limitations.

It is preferable that the thickness of the positive electrode bonding pad 18 be within the range of 100 to 1000 nm. In addition, the bonding pad has characteristics that, as the thickness thereof increases, bondability is improved. Therefore, it is more preferable that that thickness of the positive electrode bonding pad 18 be greater than or equal to 300 nm. In addition, it is preferable that the thickness of the positive electrode bonding pad be less than or equal to 500 nm from the viewpoint of manufacturing cost.

A negative electrode bonding pad 19 is formed so as to come into contact with the n-type semiconductor layer 13 as shown in the example of FIG. 1.

For this reason, when the negative electrode bonding pad 19 is formed, the light emitting layer 14 and the p-type semiconductor layer 15 are partially removed to expose the n-contact layer of the n-type semiconductor layer 13, and the negative electrode bonding pad 19 is formed on the exposed portion.

As the materials for the negative electrode bonding pad 19, negative electrodes having various compositions and structures are known and these known negative electrodes can be used without any limitations. They can be formed by a means that has been well known in this technical field.

### [Method for manufacturing gallium nitride based compound semiconductor light emitting device]

As described earlier, the method of the present invention for producing a gallium nitride based compound semiconductor light emitting device includes a first crystal growth step in which an n-type semiconductor layer 13, a light emitting layer 14, and a first p-type semiconductor layer 15 which are formed of a gallium nitride based compound semiconductor are laminated in this order on a substrate 11 as shown in FIG. 1; and a second crystal growth step in which a p-contact layer (a second p-type semiconductor layer) formed of a gallium nitride based compound semiconductor is further laminated thereon; and also has an uneven pattern forming step in which an uneven pattern is formed on a surface of the first p-type semiconductor layer 15 after the first crystal growth step and before the second crystal growth step, and a heat treatment step in which a heat treatment is carried out after the uneven pattern forming step.

In the method for producing a light emitting device of the present invention, an uneven pattern is formed on a wafer (uneven pattern forming step), in which the aforementioned first crystal growth step is completed. Then a heat treatment step is conducted, and thereafter, a second crystal growth step, in which a p-type semiconductor layer alone is laminated again, is conducted. In the production method of the present invention, the heat treatment step and the second crystal growth step play a role in rediffusing impurities to the portions where the concentration of impurities is reduced due to the dry etching process.

### <Uneven pattern forming step>

The uneven pattern forming step of the present invention includes the following intermediate steps (a) and (b).
(a) a step for forming a mask on the first p-type semiconductor layer; and
(b) a step for dry etching the surface of the first p-type semiconductor layer.

In addition, it is possible to configure the uneven pattern forming step of the present invention so that the abovementioned step (a) includes a sub-step for forming a metal thin film on the first p-type semiconductor layer and a sub-step for carrying out a heat treatment after forming the metal thin film.

The method for forming an uneven pattern on the surface of the first p-type semiconductor layer will be described in detail below using the example of a light emitting device 1 shown in FIG. 1.

First, a wafer is prepared, in which the n-type semiconductor layer 13, the light emitting layer 14, and the first p-type semiconductor layer 15 which are formed of a gallium nitride based compound semiconductor are laminated in this order on the substrate 11 with the buffer layer 12 interposed therebetween, and a common resist mask is formed on the wafer with any given pattern due to the photolithography method. Shape of the pattern at this stage may be circular, elliptic, polygonal, stripe, or the like and is selected depending on the size and shape of the light emitting device, the emission wavelength, or the like. Thereafter, the first p-type semiconductor layer 15 is etched using a common dry etching apparatus. Etching depth is preferably equal to or less than the film thickness of the first p-type semiconductor layer 15. The resist mask is removed after the dry etching process due to the organic cleaning process or the like.

Note that a metal mask (metal thin film) may be used in addition to the resist mask. When a metal mask is used, there are two ways for using it; i.e., the mask may be used in a similar manner to that of the resist mask described earlier or the mask may be formed with granules thereon by exploiting the agglomeration effects of metals. When a mask is formed by taking advantage of the agglomeration effects, the metal material is preferably a metal with a low melting point selected from the group consisting of Ni, Au, Sn, Ge, Pb, Sb, Bi, Cd, and In or an alloy with a low melting point containing at least one of these metals. In addition, the aforementioned metal with a low melting point and the alloy with a low melting point preferably have a melting point within the range of 100°C and 450°C.

The mask is formed on the wafer with any given pattern using these metals and employing a common film forming method such as a deposition method, a sputtering method, or the like, and thereafter, the metal is agglomerated by applying a heat treatment suited for the material. For example, when Ni or an Ni alloy is used, it is preferable to conduct a heat treatment within a temperature range of 300°C and 600°C in the presence of oxygen. A preferable shape in terms of light emission can be obtained by conducting a heat treatment in the above condition. An uneven pattern which reflects that of the granules of the mask is formed on the surface of the first p-type semiconductor layer by conducting a dry etching process.

Note that in the production method of the light emitting device of the present invention, it may be configured so that the metal thin film formed in the aforementioned step (a) remains in the first p-type semiconductor layer 15 or on the surface thereof after the dry etching process in the aforementioned step (b). The contact resistance between the first p-type semiconductor layer 15 and the p-contact layer (second p-type semiconductor layer) 16 can be reduced even further by the remaining metal thin film.

### <Heat treatment step>

The heat treatment step will be described below.

In the heat treatment step of the present invention, the treatment temperature is preferably greater than or equal to 250°C and more preferably greater than or equal to 500°C. In addition, the heat treatment is conducted in the presence of oxygen. However, it should be noted that when the heat treatment temperature is greater than or equal to 1,100°C, it will be likely that the MQW structure is damaged and the reverse voltage characteristics thereof may be adversely affected.

A light emitting device with a low driving voltage is obtained by conducting a heat treatment in the above conditions.

In addition, although the role of oxygen in this heat treatment step is not clear yet, satisfactory experimental results are obtained when it is present (refer to the Examples described later).

Since it is not preferable to conduct a heat treatment step in the presence of oxygen in an MOCVD furnace where hydrogen is used for safety reasons, it is preferable to carry out the heat treatment step in a heating apparatus other than the MOCVD furnace.

### <Second crystal growth step>

The second crystal growth step will be described in detail below.

In the present invention, an uneven pattern is formed by the aforementioned uneven pattern forming step and the heat treatment step on the surface of the first p-type semiconductor layer 15 that is laminated in the first crystal growth step, and thereafter, the p-contact layer (second p-type semiconductor layer) is further laminated in the second crystal growth step.

The p-contact layer laminated in the second crystal growth step of the present invention is a gallium nitride based compound semiconductor layer containing at least AlₑGa₁₋ₑN (0 ≤ e < 0.5, preferably, 0 ≤ e ≤ 0.2, more preferably, 0 ≤ e ≤ 0.1) as described earlier. It is preferable that the A1 composition be within the above range for maintaining satisfactory crystallinity and for satisfactory ohmic contact with a p-ohmic electrode. In addition, it is preferable that the p-type dopant concentration be within the range of 1 × 10¹⁸ to 1 × 10²¹/cm³ for maintaining a satisfactory ohmic contact, preventing the occurrence of cracks, and maintaining satisfactory crystallinity, and more preferably, the concentration is within the range of 5 × 10¹⁹ to 5 × 10²⁰/cm³. Although p-type impurities are not particularly limited, preferable examples thereof include Mg.

Film thickness of the p-contact layer differs depending on the method used in the step for forming an uneven pattern on the surface of the first p-type semiconductor layer, on which the p-contact layer is laminated. For example, when the formation of an uneven pattern is conducted by preparing a common resist mask with any given pattern due to a photolithography method, the film thickness is preferably within the range of 50 to 500 nm. When the film thickness of the p-contact layer is too large, the uneven pattern will be planarized. Accordingly, it is not preferable from the viewpoint of light emission. On the other hand, when the film thickness of the p-contact layer is too small, an inclined crystal plane does not develop, and thus it is not preferable from the viewpoint of the step coverage characteristics of a translucent positive electrode.

According to the method for producing a gallium nitride based compound semiconductor light emitting device of the present invention, a gallium nitride based compound semiconductor light emitting device that is excellent in terms of light emission efficiency and is capable of operating at a low driving voltage is obtained by adopting the abovementioned configuration. In addition, the production method of the present invention has effects, especially the following effects (1) and (2).
(1) an uneven pattern with no damage caused by the dry etching process can be formed on the surface of the first p-type semiconductor layer.
(2) A crystal plane inclined with respect to the substrate normal direction is exposed in the surface since the second p-type semiconductor layer is laminated and regrown. Due to this, the step coverage characteristics of the translucent positive electrode improve.

Due to these effects, a gallium nitride based compound semiconductor light emitting device that is excellent in terms of light emission efficiency and is capable of operating at a low driving voltage is obtained.

### [Lamp configuration]

A lamp can be formed by providing a transparent cover to the gallium nitride based compound semiconductor light emitting device due to, for
example, a known means for those skilled in the art. In addition, it is possible to form a white lamp by combining the gallium nitride based compound semiconductor light emitting device with a cover including a phosphor.

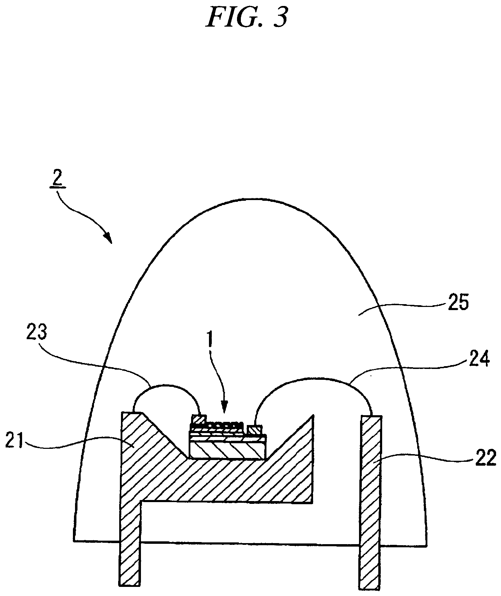

FIG. 3 is a cross sectional diagram schematically showing one example of a lamp. The light emitting device 1 composed
of a face-up type nitride based semiconductor shown in FIG. 1 is implemented in a cannonball shape in this lamp 2. In FIG. 3, reference numerals 21 and 22 indicate frames, 23 and 24 indicate wires, and 25 indicates a mold.

The lamp 2 can be produced by a conventionally known method using the light emitting device 1 of the present invention shown in FIG. 1. More specifically, a cannonball shaped lamp shown in FIG. 3 can be produced by, for example, adhering the light emitting device 1 to one of the two frames 21 and 22 (frame 21 in the case shown in FIG. 3) using resin or the like, joining the positive electrode and the negative electrode of the light emitting device 1 (refer to those indicated by reference numerals 18 and 19 in FIG. 1) with the frames 21 and 22, respectively through the wires 23 and 24 made of materials such as gold, and thereafter molding the periphery of the light emitting device 1 with a mold 25 made of transparent resin.

Note that the lamp can be used for various types of lamps,
such as a general-purpose cannonball shaped lamp, a side view type lamp as a backlight of a mobile phone, or a top view type lamp used for a display device.

Since, the light emitting device has excellent light
emission efficiency, it is possible to achieve a lamp having excellent light emitting properties.

### EXAMPLES

Next, the light emitting device of the present invention and the lamp using the device will be described in more detail with reference to Examples.

### [Example 1]

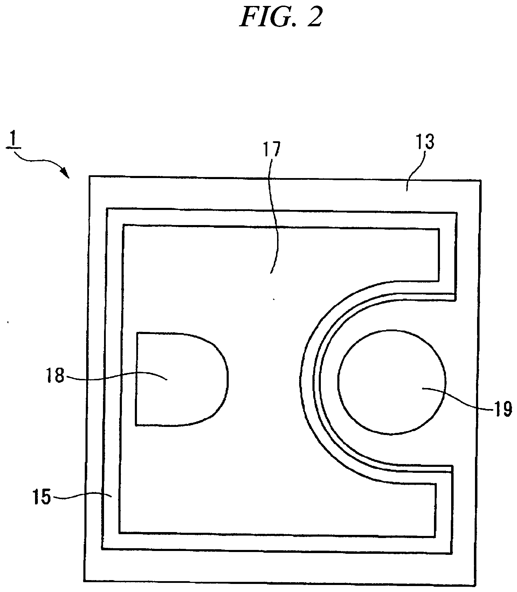

FIG. 1 is a cross sectional view schematically illustrating a gallium nitride based compound semiconductor light emitting device produced in Example 1, and FIG. 2 is a plan view of the same.

### [Production of gallium nitride based compound semiconductor light emitting device]

A gallium nitride based compound semiconductor layer was laminated on a sapphire substrate 1 with a buffer layer 12 made of AlN interposed therebetween. The gallium nitride based compound semiconductor layer was formed by laminating the n-type semiconductor layer 13, the light emitting layer 14, and the first p-type semiconductor layer 15 in this order. The n-type semiconductor layer 13 was formed by laminating an undoped GaN underlying layer with a thickness of 8 µm, a Ge-doped n-type GaN contact layer with a thickness of 2 µm, and an n-type In_{0.1}Ga_{0.9}N cladding layer with a thickness of 0.02 µm in this order. The light emitting layer 14 having a multiple quantum well structure was formed by providing a barrier layer on five laminates of a Si-doped GaN barrier layer with a thickness of 16 nm and an In_{0.06}Ga_{0.94}N well layer with a thickness of 2.5 nm. The p-type semiconductor layer 15 was formed by laminating a Mg-doped p-type Al_{0.07}Ga_{0.93}N cladding layer with a thickness of 0.01 µm and a Mg-doped p-type Al_{0.02}Ga_{0.98}N contact layer with a thickness of 0.5 µm. The semiconductor was configured such that light was emitted from the surface of the semiconductor layer.

### (Formation of uneven pattern)

Next, a resist mask was formed in a dot pattern on the aforementioned p-contact layer using a common photolithography method. After the dry etching process at a depth of 0.4 µm, the resist mask was removed by the organic cleaning process. Then an annealing process was conducted at 600°C for 1 minute in an atmosphere where the oxygen concentration was 1%.

### (Lamination of p-contact layer)

Next, a Mg-doped p-type Al_{0.02}Ga_{0.98}N contact layer 16 with a thickness of 0.1 µm was further laminated on the p-type semiconductor layer 15, in which the uneven pattern was formed on the surface thereof.

In this structure, the carrier concentration of the n-type GaN contact layer was 1 × 10¹⁹ cm⁻³, and the doping amount of Si in the GaN barrier layer was 1 × 10¹⁷ cm⁻³. The carrier concentration of the p-type AlGaN contact layer was 5 × 10¹⁸ cm⁻³, and the doping amount of Mg in the p-type AlGaN cladding layer was 5 × 10¹⁹ cm⁻³.

In addition, the laminated structure of the gallium nitride based compound semiconductor layer (reference numerals 12, 13, 14, 15, and 16 in FIG. 1) was formed by an MOCVD method under the usual conditions well known in the technical field.

Then, the n-type GaN contact layer in a region for forming the negative electrode was exposed from the gallium nitride based compound semiconductor layer by a reactive ion etching method.

First, a resist was uniformly applied on the entire surface of the p-type semiconductor layer to form an etching mask, and the resist was then removed from the region for forming the negative electrode by a known lithography technique. Then, the laminated structure was put into a vacuum deposition apparatus, and Ni and Ti were deposited at a pressure of 4 × 10⁻⁴ Pa or less by an electron beam method to form films with thicknesses of 50 nm and 300 nm, respectively. Thereafter, the resist and a metal film other than the region for forming the negative electrode were removed by a lift-off technique.

Then, a semiconductor laminated substrate was mounted on the electrode in an etching chamber of the reactive ion etching apparatus and the pressure of the etching chamber was reduced to 10⁻⁴ Pa. Thereafter, the semiconductor laminate was etched until the n-type GaN contact layer was exposed by supplying Cl₂, serving as an etching gas. After the etching process, the semiconductor laminate was taken out from the reactive ion etching apparatus, and the etching mask was removed by nitric acid and fluoric acid.

### (Formation of translucent positive electrode)

Next, a Ni contact metal layer with a thickness of 1 nm and a current spreading layer made of ITO were formed only in the region for forming the positive electrode on the p-type AlGaN contact layer 16 employing a known photolithography technique and a known lift-off technique. In the formation of the current spreading layer, the substrate having the gallium nitride based compound semiconductor layer laminated thereon was first put into a vacuum sputtering apparatus and ITO with a thickness of 1 µm was deposited on the Ni contact metal layer.

Then, the substrate was taken out from the vacuum chamber, and by performing a heat treatment in order to improve transparency, the translucent positive electrode 17 was formed.

### (Formation of positive electrode bonding pad)

Next, a first layer made of Au, a second layer made of Ti, a third layer made of Al, a fourth layer made of Ti, and a fifth layer made of Au were sequentially laminated on a portion of the translucent positive electrode by a known procedure usually called lift-off and the same deposition method as described above, thereby forming the positive electrode bonding pad 18.

### (Formation of negative electrode bonding pad)

Then, the negative electrode bonding pad 19 was formed on the exposed n-type GaN contact layer by the following procedures. A resist was uniformly applied on the entire surface of the n-type GaN contact layer, and the resist was removed from a portion for forming the negative electrode on the exposed n-type GaN contact layer by a known lithography technique. Then, Ti and Au were respectively deposited with a thickness of 100 nm and 200 nm on the semiconductor by a general vacuum deposition method in this order, thereby forming the negative electrode bonding pad 19. Then, the resist was removed by a known method.

### (Device division)

Then, the back surface of the substrate 11 in the wafer having the positive electrode and the negative electrode formed thereon as described above was ground/polished such that the thickness of the substrate 11 was reduced to 80 µm, and a laser scriber was used to mark the semiconductor. Then, the semiconductor was cut into chips each having a 350 µm square.

### <Evaluation of light emitting device>

The chip obtained as described above was mounted on a stem and an electric current of 20 mA was applied thereto to measure a forward voltage, which was 3.3 V. The emission power was 13 mW.

In addition, the chip was mounted to a TO-18 package, and the emission power thereof was measured by a tester. When an electric current of 20 mA was applied, the emission power was 20 mW. The emission power was about 1.3-fold that of a chip, in which no uneven pattern was formed in the p-type semiconductor layer. In addition, in terms of light emission distribution in the light emitting surface, it was verified that light was emitted from the entire surface of the positive electrode.

### [Examples 2 to 6 and Comparative Example 1]

The light emitting devices of Examples 2 to 6 and Comparative Example 1 were produced in a similar manner to that of Example 1 except that the heat treatment conditions were changed to those shown in the following Table 1. In addition, the same evaluations as those made in Example 1 were made and the results thereof are shown in the following Table 1.

**[Table 1]**

| | Oxygen concentration (%) | Temperature (°C) | Po (mW) | Vf (V) |
|---|---|---|---|---|
| Comp. Ex. 1 | No annealing process | | 10 | 4.0 |
| Ex. 2 | 0.0 | 500 | 12 | 3.8 |
| Ex. 3 | 0.1 | 500 | 13 | 3.3 |
| Ex. 4 | 1.0 | 500 | 13 | 3.3 |
| Ex. 5 | 0.1 | 250 | 12 | 3.8 |
| Ex. 6 | 0.1 | 750 | 13 | 3.3 |

As shown in Table 1, the emission powers were greater than or equal to 12 mW and the driving voltages were within the range of 3.3 and 3.8 V in all the light emitting devices of Examples 2 to 6, in which the formation of an uneven pattern on the surface of the first p-type semiconductor layer 15 and the heat treatment thereto were conducted and the p-contact layer 16 is further laminated thereon in the conditions specified by the production method of the present invention.

On the other hand, in the light emitting device of Comparative Example 1 where a heat treatment was not conducted after the formation of an uneven pattern on the surface of the first p-type semiconductor layer, the emission power was low (10 mW) and the driving voltage was high (4.0 V) compared to those exhibited by the light emitting devices of the respective Examples.

### [Example 7]

An AlN buffer layer 12 and gallium nitride based compound semiconductor layers 13 to 15 were laminated on a sapphire substrate in a similar manner to that in Example 1. Then, the resulting laminated body was put in a deposition apparatus and Ni was deposited with a thickness of 150 nm on the entire surface of the p-contact layer.

Next, a heat treatment was performed at a temperature of 600°C in an atmosphere where the oxygen concentration was 0.2% to agglomerate the thin film of the deposited Ni, thereby forming a mask made of metal particles. The mask was subjected to a dry etching process at a depth of 0.4 µm. It was verified by microscopic observation that the trace amount of Ni remained on the surface after the dry etching process.

Then, an annealing process was conducted at 600°C for 1 minute in an atmosphere where the oxygen concentration was 1 %. Thereafter, a Mg-doped p-type Al_{0.02}Ga_{0.98}N contact layer with a thickness of 0.1 µm was further laminated thereon.

The method for forming the positive electrode and the negative electrode, the process for grinding/polishing the back surface of the substrate, and the method for dividing semiconductor laminates into chips were the same as those employed in Example 1. The obtained chip was mounted on a stem and an electric current of 20 mA was applied thereto to measure a forward voltage, which was 3.2 V. The integrating sphere output was 14 mW.

In addition, the chip was mounted to a TO-18 package, and the emission power thereof was measured by a tester. When an electric current of 20 mA was applied, the emission power was 22 mW. In addition, in terms of light emission distribution in the light emitting surface, it was verified that light was emitted from the entire surface of the positive electrode.

It is apparent from the abovementioned results that the light emitting device obtained by the production method of the present invention has excellent light emission efficiency and high device characteristics.

### INDUSTRIAL APPLICABILITY

The present invention can be applied to a method for producing a gallium nitride based compound semiconductor light emitting device, in particular, a method for producing a gallium nitride based compound semiconductor light emitting device having excellent light emitting properties.

## Claims

1. A method for producing a gallium nitride based compound semiconductor light emitting device (1), the method comprising:
a first crystal growth step in which an n-type semiconductor layer (13), a light emitting layer (14), and a first p-type semiconductor layer (15) which are formed of a gallium nitride based compound semiconductor are laminated in this order on a substrate (11);
a second crystal growth step in which a second p-type semiconductor layer (16) formed of a gallium nitride based compound semiconductor is further laminated thereon;
an uneven pattern forming step in which an uneven pattern is formed on a surface of the first p-type semiconductor layer (15) after the first crystal growth step and before the second crystal growth step; and
a heat treatment step in which a heat treatment is carried out after the uneven pattern forming step and before the second crystal growth step, **characterized in that**
the heat treatment step is carried out in an oxygen atmosphere and the uneven pattern forming step includes the following intermediate steps (a) and (b):
(a) a step for forming a mask on the first p-type semiconductor layer (15); and
(b) a step for dry etching a surface of the first p-type semiconductor layer (15) through the mask.

2. The method for producing a gallium nitride based compound semiconductor light emitting device according to Claim 1,
wherein a heat treatment temperature in the heat treatment step is greater than or equal to 250°C.

3. The method for producing a gallium nitride based compound semiconductor light emitting device according to Claim 1,
wherein a heat treatment temperature in the heat treatment step is greater than or equal to 500°C.

4. The method for producing a gallium nitride based compound semiconductor light emitting device according to Claim 1,
wherein the mask is formed on the first p-type semiconductor layer (15) in the step (a) by carrying out a patterning process using a resist material.

5. The method for producing a gallium nitride based compound semiconductor light emitting device according to Claim 1,
wherein the step (a) includes a sub-step for forming a metal thin film on the first p-type semiconductor layer (15) and a sub-step for carrying out a heat treatment after forming the metal thin film.

6. The method for producing a gallium nitride based compound semiconductor light emitting device according to Claim 5,
wherein the metal thin film formed in step (a) remains in the first p-type semiconductor layer (15) or on a surface thereof after a dry etching process in the step (b).

7. The method for producing a gallium nitride based compound semiconductor light emitting device according to Claim 5 or 6,
wherein the metal thin film is made of a low melting point metal or a low melting point alloy which has a melting point of 100°C to 450°C.

8. The method for producing a gallium nitride based compound semiconductor light emitting device according to Claim 5 or 6,
wherein the metal thin film is made of Ni or a Ni alloy.

9. The method for producing a gallium nitride based compound semiconductor light emitting device according to any one of Claims 5 to 8,
wherein the metal thin film is made of a low melting point metal selected from the group consisting of Ni, Au, Sn, Ge, Pb, Sb, Bi, Cd, and In or a low melting point alloy containing at least one of these metals.

## Patentansprüche

1. Verfahren zum Herstellen einer galliumnitridbasierten Verbindungshalbleiterlichtemissionsvorrichtung (1), wobei das Verfahren umfasst:
eine erste Kristallwachstumsstufe, in der eine Halbleiterschicht vom n-Typ (13), eine Lichtemissionsschicht (14) und eine erste Halbleiterschicht vom p-Typ (15), die aus einem galliumnitridbasierten Verbindungshalbleiter gebildet sind, in dieser Reihenfolge auf ein Substrat (11) laminiert werden;
eine zweite Kristallwachstumsstufe, in der eine aus einem galliumnitridbasierten Verbindungshalbleiter gebildete zweite Halbleiterschicht vom p-Typ (16) außerdem darauf laminiert wird;
eine Stufe zum Bilden eines unebenen Musters, in der ein unebenes Muster auf einer Oberfläche der ersten Halbleiterschicht vom p-Typ (15) nach der ersten Kristallwachstumsstufe und vor der zweiten Kristallwachstumsstufe gebildet wird; und
eine Hitzebehandlungsstufe, in der eine Hitzebehandlung nach der Stufe zum Bilden des unebenen Musters und vor der zweiten Kristallwachstumsstufe durchgeführt wird,
**dadurch gekennzeichnet, dass**
die Hitzebehandlungsstufe in einer Sauerstoffatmosphäre durchgeführt wird und die Stufe zum Bilden des unebenen Musters die folgenden Zwischenschritte (a) und (b) umfasst:
(a) eine Stufe, in der auf der ersten Halbleitschicht vom p-Typ (15) eine Maske gebildet wird; und
(b) eine Stufe, in der eine Oberfläche der ersten Halbleiterschicht vom p-Typ (15) durch die Maske trockengeätzt wird.

2. Verfahren zum Herstellen einer galliumnitridbasierten Verbindungshalbleiterlichtemissionsvorrichtung nach Anspruch 1,
wobei die Hitzebehandlungstemperatur in der Hitzebehandlungsstufe größer oder gleich 250°C ist.

3. Verfahren zum Herstellen einer galliumnitridbasierten Verbindungshalbleiterlichtemissionsvorrichtung nach Anspruch 1,
wobei die Hitzebehandlungstemperatur in der Hitzebehandlungsstufe größer oder gleich 500°C ist.

4. Verfahren zum Herstellen einer galliumnitridbasierten Verbindungshalbleiterlichtemissionsvorrichtung nach Anspruch 1,
wobei die Maske auf der ersten Halbleiterschicht vom p-Typ (15) in der Stufe (a) gebildet wird, indem ein Musterbildungsverfahren unter Einsatz eines Resistmaterials durchgeführt wird.

5. Verfahren zum Herstellen einer galliumnitridbasierten Verbindungshalbleiterlichtemissionsvorrichtung nach Anspruch 1,
wobei die Stufe (a) eine Unterstufe zum Bilden eines dünnen Metallfilms auf der ersten Halbleiterschicht vom p-Typ (15) und eine Unterstufe zum Durchführen einer Hitzebehandlung nach dem Bilden des dünnen Metallfilms umfasst.

6. Verfahren zum Herstellen einer galliumnitridbasierten Verbindungshalbleiterlichtemissionsvorrichtung nach Anspruch 5,
wobei der in Stufe (a) gebildete dünne Metallfilm in der ersten Halbleiterschicht vom p-Typ (15) oder auf einer Oberfläche davon nach dem in Stufe (b) durchgeführten Trockenätzverfahren verbleibt.

7. Verfahren zum Herstellen einer galliumnitridbasierten Verbindungshalbleiterlichtemissionsvorrichtung nach Anspruch 5 oder 6,
wobei der dünne Metallfilm aus einem Metall mit niedrigem Schmelzpunkt oder einer Legierung mit niedrigem Schmelzpunkt gebildet ist, wobei der Schmelzpunkt 100 bis 450°C ist.

8. Verfahren zum Herstellen einer galliumnitridbasierten Verbindungshalbleiterlichtemissionsvorrichtung nach Anspruch 5 oder 6,
wobei der dünne Metallfilm aus Nickel oder einer Nickellegierung besteht.

9. Verfahren zum Herstellen einer galliumnitridbasierten Verbindungshalbleiterlichtemissionsvorrichtung nach einem der Ansprüche 5 bis 8,
wobei der dünne Metallfilm aus einem Metall mit niedrigem Schmelzpunkt, ausgewählt aus der aus Ni, Au, Sn, Ge, Pb, Sb, Bi, Cd und In bestehenden Gruppe, oder aus einer mindestens eines dieser Metalle enthaltenden Legierung mit niedrigem Schmelzpunkt gebildet ist.

## Revendications

1. Procédé de fabrication d'un dispositif électroluminescent à base de composé semi-conducteur de nitrure de gallium (1), le procédé comprenant:
une première étape de croissance cristalline dans laquelle une couche de semi-conducteur de type n (13), une couche émettant de la lumière (14) et une première couche de semi-conducteur de type p (15) qui sont constituées d'un composé semi-conducteur à base de nitrure de gallium sont stratifiées dans cet ordre sur un substrat (11);
une seconde étape de croissance cristalline dans laquelle une seconde couche de semi-conducteur de type p (16) constituée d'un composé semi-conducteur à base de nitrure de gallium est en outre stratifiée sur celui-ci;
une étape de formation d'un motif irrégulier dans laquelle un motif irrégulier est formé sur une surface de la première couche de semi-conducteur de type p (15) après la première étape de croissance cristalline et avant la seconde étape de croissance cristalline; et
une étape de traitement thermique dans laquelle un traitement thermique est exécuté après l'étape de formation d'un motif irrégulier et avant la seconde étape de croissance cristalline,
**caractérisé en ce que** l'étape de traitement thermique est exécutée dans une atmosphère d'oxygène, et l'étape de formation d'un motif irrégulier comprend les étapes intermédiaires (a) et (b) suivantes:
(a) une étape pour former un masque sur la première couche de semi-conducteur de type p (15); et
(b) une étape de gravure sèche d'une surface de la première couche de semi-conducteur de type p (15) à travers le masque.

2. Procédé de fabrication d'un dispositif électroluminescent à base de composé semi-conducteur de nitrure de gallium selon la revendication 1, dans lequel une température de traitement thermique à l'étape de traitement thermique est supérieure ou égale à 250°C.

3. Procédé de fabrication d'un dispositif électroluminescent à base de composé semi-conducteur de nitrure de gallium selon la revendication 1, dans lequel une température de traitement thermique à l'étape de traitement thermique est supérieure ou égale à 500°C.

4. Procédé de fabrication d'un dispositif électroluminescent à base de composé semi-conducteur de nitrure de gallium selon la revendication 1, dans lequel le masque est formé sur la première couche de semi-conducteur de type p (15) à l'étape (a) en exécutant un procédé de structuration en utilisant un matériau protecteur.

5. Procédé de fabrication d'un dispositif électroluminescent à base de composé semi-conducteur de nitrure de gallium selon la revendication 1, dans lequel l'étape (a) inclut une sous-étape pour former un film de métal mince sur la première couche de semi-conducteur de type p (15) et une sous-étape pour exécuter un traitement thermique près la formation du film de métal mince.

6. Procédé de fabrication d'un dispositif électroluminescent à base de composé semi-conducteur de nitrure de gallium selon la revendication 5, dans lequel le film de métal mince formé à l'étape (a) reste dans la première couche de semi-conducteur de type p (15) ou sur une surface de celle-ci après un procédé de gravure sèche à l'étape (b).

7. Procédé de fabrication d'un dispositif électroluminescent à base de composé semi-conducteur de nitrure de gallium selon la revendication 5 ou 6, dans lequel le film de métal mince est constitué d'un métal à bas point de fusion ou d'un alliage à bas point de fusion dont le point de fusion est compris entre 100°C et 450°C.

8. Procédé de fabrication d'un dispositif électroluminescent à base de composé semi-conducteur de nitrure de gallium selon la revendication 5 ou 6, dans lequel le film de métal mince est constitué de Ni ou d'un alliage de Ni.

9. Procédé de fabrication d'un dispositif électroluminescent à base de composé semi-conducteur de nitrure de gallium selon l'une quelconque des revendications 5 à 8, dans lequel le film de métal mince est constitué d'un métal à bas point de fusion sélectionné dans le groupe comprenant le Ni, l'Au, le Sn, le Ge, le Pb, le Sb, le Bi, le Cd et l'In ou d'un alliage à bas point de fusion contenant au moins un de ces métaux.
